## Europäisches Patentamt

## European Patent Office

## Office européen des brevets

(11) Publication number: **0 126 879**
**B1**

## EUROPEAN PATENT SPECIFICATION

(45) Date of publication of patent specification: **21.01.87**

(51) Int. Cl.⁴: **H 01 L 27/08**

(21) Application number: **84103094.3**

(22) Date of filing: **21.03.84**

(54) Integrated circuit arrangement.

(30) Priority: **24.03.83 GB 8308113**

(43) Date of publication of application:
**05.12.84 Bulletin 84/49**

(45) Publication of the grant of the patent:
**21.01.87 Bulletin 87/04**

(84) Designated Contracting States:
**AT BE CH DE FR IT LI LU NL SE**

(56) References cited:
**GB-A-1 434 961**
**US-A-2 569 347**
**US-A-3 823 353**

**PROCEEDINGS OF THE IEEE, vol. 70, no. 1,
January 1982, New York, USA H. KROEMER
"Heterostructure bipolar transistors and
integrated circuits", pages 13-25**

(73) Proprietor: **PLESSEY OVERSEAS LIMITED
Vicarage Lane
Ilford Essex IGI 4AQ (GB)**

(72) Inventor: **Sumerling, Geoffrey William
26 The Slade
Silverstone Northants (GB)**
Inventor: **Goodfellow, Robert Charles
4 Hawthorn Drive
Brackley Northants (GB)**

(74) Representative: **Fish, Norman Ernest
The Plessey Company plc
Intellectual Property Department
Vicarage Lane
Ilford Essex IG1 4AQ (GB)**

Courier Press, Leamington Spa, England.

## Description

This invention relates to an integrated circuit arrangement and more particularly to an Integrated injection Logic ($I^2L$) circuit arrangement.

In our British Patent GB—A—1434961 there is disclosed a substrate fed $I^2L$ arrangement in which both npn and pnp transistors are vertical geometry devices with the p type emitter acting as a buried injector, common with the substrate. The n type base of this transistor is connected to earth at regular but spaced out points on the circuit surface. The remainder of the chip surface can be used for the logic gate interconnections. This arrangement provides much improved packing density as compared with conventional $I^2L$ where the pnp transistor is usually implemented as a transverse geometry device. However, the arrangement described in this patent requires a compromise in relative doping levels of the layers in order to satisfy the operating requirements of pnp and npn transistors.

The present invention seeks to provide a structure which enables the before mentioned compromise to be avoided.

According to the invention there is provided an integrated circuit arrangement having at least one pair of superposed transistor structures, the arrangement comprising first, second and third superposed semiconductor layers, the second layer being of opposite conductivity type to the first and third layers, at least one electrical contact formed on a surface of the third layer, at least one semiconductive region of the same conductivity type as the second layer formed in or on the said surface of the third layer, an electrical connection to the or each of the semiconductive region(s) and an electrical connection to the first layer, wherein at least the second and third layers form a heterojunction ensuring a high injection efficiency of minority carrier independant of the doping level of either layer. By employing such a heterojunction to provide preferential injection between second and third layers, the third layer can thus be made heavily doped to reduce lateral resistance in that layer as the doping has negligible effect on injection. It also permits the doping of the other layers and region(s) to be optimised to enhance the operating speed of the arrangement.

The electrical contact to the first layer may comprise a layer of electrical contact material formed on a surface of the first layer.

The first layer may be formed on a semiconductor substate of like polarity type. The layers may be formed on the substrate by epitaxial deposition. The substrate may be of a conductive type and a layer of contact material may be formed on a surface opposite the first layer to provide said electrical connection to the first layer.

The first and second layers may form a heterojunction as may the semiconductive region(s) and the third layer.

The second layer may be arranged to have a doping density higher than the first layer but lower than the third layer.

The doping density at the surface of the third layer beneath said at least one electrical contact may be more heavily doped or have a wider band gap than the remainder of the layer.

The arrangement may be provided with N said semiconductive regions forming the collectors of a multicollector $I^2L$ circuit and the current gain of the transistor is arranged to be substantially 2N.

The arrangement may be fabricated in any mixed group 111-V materials for example Gallium Arsenide and Gallium Aluminium Arsenide or Gallium Indium Arsenide and Indium phosphide.

The doping density of the third layer may be arranged such that said at least one electrical contact forms a Schottky diode with the third layer.

The arrangement may have a plurality of pairs of superposed transistor structures wherein, the first and second layers are common to all of the pairs and wherein the third layer is divided into a number of separate sections which are isolated from each other and which are each associated with a separate one of the pairs, each of the separate sections having at least one electrical contact formed on the surface therof, at least one said semiconductive region formed in or on the surface thereof and an electrical contact for each of the semiconductive regions. The separate sections may be isolated from each other by an interconnected isolation strip which is adapted to provide an electrical contact rail for the second layer or by mesa etching through the third layer to the second layer beneath.

At least one island may be formed by providing an isolating region which extends down to the substrate, which island is used to fabricate an individual transistor, diode, resistor, capacitor or circuit on the same chip as the pairs(s) of superposed transistor structures. The isolating regions may.be formed by mesa etching, proton implantation or p-type dopant implantation.

In order that the invention and its various other preferred features may be understood more easily, embodiments thereof will now be described, by way of example only, with reference to the drawings, in which:—

Figure 1 is a schematic illustration showing the layers of an integrated circuit arrangement in accordance with our British patent No. 1434961,

Figure 2 is a schematic illustration of the layers of a heterojunction transistor;

Figure 3 is a cross sectional view of an integrated circuit arrangement constructed in accordance with the invention;

Figure 4 illustrates a multicollector logic configuration;

Figure 5 illustrates the equivalent circuit of the logic configuration of Figure 2;

Figure 6 diagramatically illustrates in plan view an array of the integrated circuit arrangements in accordance with the invention.

Figure 7 is a schematic illustration of an epitaxial layer structure prior to processing to form an integrated circuit arrangement in accordance with the invention and;

Figure 8 is a table showing two examples of structure in accordance with the invention with their material type and doping density.

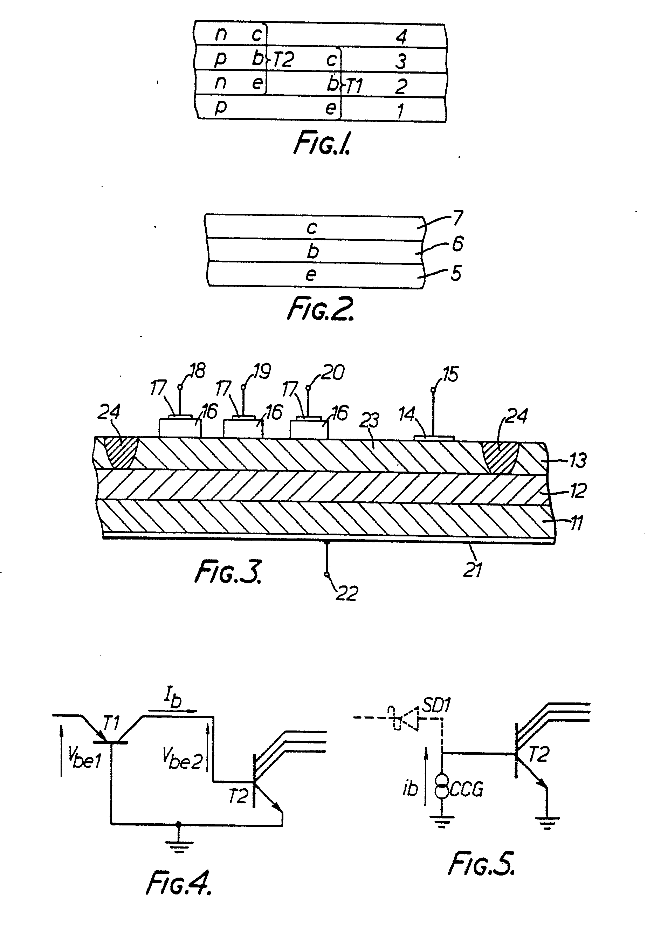

The drawing of Figure 1 shows a silicon layer arrangement suitable for forming a vertical geometry $I^2L$ circuit as described in our British Patent GB—A—1434961. As can be seen the first and third layers 1, 3 are of p-type conductivity and the second and fourth layers 2, 4 are of n-type conductivity. The layers 1, 2 and 3 can be used to form emitter base and collector of a pnp transistor T1 whilst the layers 2, 3 and 4 can be used to form emitter, base and collector an npn transistor. In such a construction the layer 2 must have a doping density less than layer 1 and higher than layer 3 to ensure that efficient injection occurs from the emitters. However, in order to provide a low base resistance in the transistor T2 to enable high speed switching, the layer 3 is required to be as highly doped as possible. It will be appreciated that these two requirements are conflicting and the doping density is a compromise.

Referring now to Figure 2 a heterojunction layer structure is illustrated and comprises a wide band gap emitter layer 5 a narrow band gap base layer 6 and a wide band gap collector layer 7. Suitable materials are Gallium Aluminium Arsenide for layers 5 and 7 and Gallium arsenide for layer 6. The hetero junction between layers 5 and 6 ensures a high injection efficiency of minority carrier from region 5 into region 6 which is substantially independent of the doping levels of either layer. Parasitic recombination and charge storage in region 5 is thus minimised.

If the transistor becomes saturated, i.e. the junction between layer 6 and 7 becomes forward biased then a hetero junction will ensure a similar high injection efficiency for the minority carriers injected from region 7 into region 6.

By fabricating the configuration of Figure 1 at least layers 2 and 3 formed from mixed group 111-V materials so as to form a heterojunction, preferential injection in transistor T2 can be ensured and the doping density of layer 3 can be made higher than layer 2 to provide low base resistance for transistor T2 without sacrificing injection efficiency. Preferably all junctions are formed as heterojunctions as illustrated in the embodiment of the invention in Figure 3. Note that the operation of $I^2L$ fundamentally depends on the saturation of transistor T2 and hence a hetero junction will benefit its operation.

In Figure 3 four superposed layers 11, 12, 13, 16 of semiconductor mixed group 111-V materials are formed in this configuration in any known manner e.g. by molecular beam epitaxy (MBE), metal organic vapour deposition (MOCVD) or liquid phase epitaxy. The layer 12 is of the opposite conductivity type to the layers 11 and 13 and has a band gap which is wider than the layer 13. Increased injection efficiency can also be achieved by using a band gap for layer 11 which is wider than that of layer 12.

An electrical contact 14 is formed, in any known manner, on the surface of the region 23 of the layer 13 and is connected to a terminal 15. The region 23 is isolated from the remainder of the layer 13 by a surrounding section 24 which is of the same conductivity type as the layer 12, for example n-type but of higher carrier concentration. The section 24 can be a diffused or implanted region. Alternatively, the surrounding section 24 could be removed, for example by etching, in order to effect the isolation, or the section 24 could be a strip of a dielectric material.

A number, for example three, spaced-apart regions 16 of the same conductivity type as the layer 12 are formed in any known manner e.g. by etching from a further layer of epitaxially deposited group 111-V material on the surface of the region 23 of the layer 13. In an optimum structure the band width of layer 16 is wider than that of layer 13. An electrical contact 17 is formed in any known manner, on each of the semiconductive regions 16 and these electrical contacts are each connected to a separate terminal, for example the terminals 18, 19 and 20.

A layer 21 of an electrical contact material is formed, in any known manner, on the surface of the layer 11 and is connected to a terminal 22.

In one example of the integrated circuit arrangement according to Figure 3, the layer 12 and the semiconductive regions 16 can be of n-type conductivity in which case the layers 11 and 13 would be of p-type conductivity.

The doping density of the layer 13 can be such that the electrical contact 14 forms a Schottky diode with the layer 13. If desired, further electrical contacts 14 could be formed on the layer 13 in order to provide further Schottky diodes. Typical material types and doping densities for the layers are shown in the table of figure 8. The arrangement is such that the multicollector transistor will have a relatively high gain.

The integrated circuit arrangement according to the invention consists of two superposed transistor structures i.e. a pnp transistor beneath a multicollector npn transistor in the exemplified arrangement given in a preceding paragraph.

The integrated circuit arrangement according to the invention is particularly useful in the realisation of multicollector logic configurations.

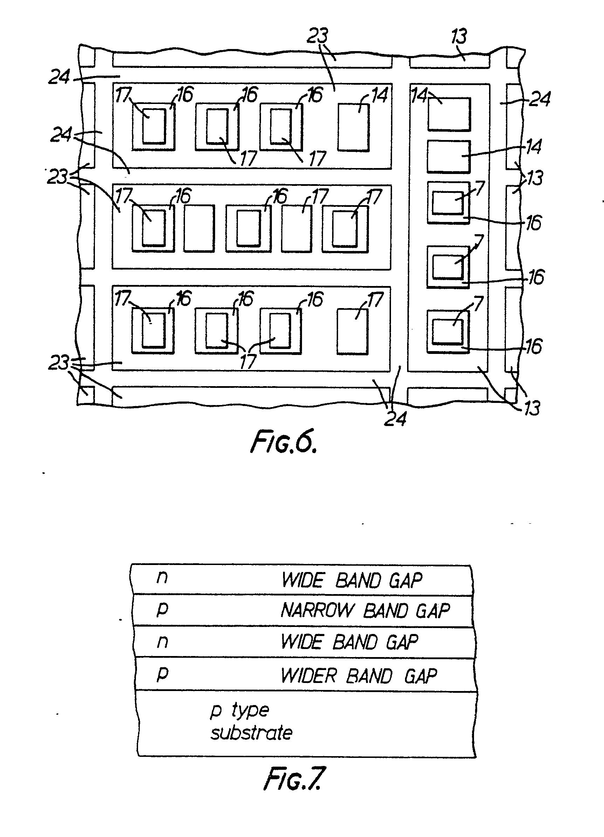

Multicollector logic (MCL) is known and, as is illustrated in Figure 4 of the drawings, consists of a pnp transistor T1 whose collector is connected to the base of a multicollector npn transistor T2. The base of the transistor T1 and the emitter of the transistor T2 are both connected to earth potential.

If the base-emitter voltage $V_{be1}$ of the transistor T1 is kept constant then the base current $i_b$ of the transistor T2 will also be constant. Under these conditions the MCL of Figure 3 can be represented by the equivalent circuit illustrated in Figure 5 of the drawings wherein the transistor T1 is shown as a constant current generator CCG.

In operation, the base-emitter voltage $V_{be2}$ of the transistor T2 must be less than $V_{be1}$ in order to ensure that the transistor T1 does not saturate heavily. The basic logic characteristic of this gate is that of an inverter with many separate outputs, the outputs being the collectors of the transistor T2 and the input being the base of the transistor T2. A gate of this type can be used to drive a similar gate by connecting one of its outputs to the input of the other gate.

Thus, with the exemplified integrated circuit arrangement given in a preceding paragraph, the pnp transistor T1 would be formed by the region 23 of the layer 13 and the layers 12 and 11, and the multicollector npn transistor T2 would be formed by the semiconductive regions 16, the region 23 of the layer 13 and the layer 12.

In the construction described the injection efficiency is enhanced by a factor exp ($\Delta$Eg/KT where $\Delta$Eg is the difference in band gap of the material of the emitter and the base of the transistor. The increased injection efficiency can be employed to increase the common emitter current gain of both the upward current source pnp transistor T1 and the upward switching npn transistor T2. In addition parasitic charge storage in the emitter, region 12, and collector regions 16 of the npn transistor can be substantially reduced. Additionally because the injection efficiency can be almost independent of the emitter and collector doping the latter can be kept low near the emitter base and collector base junctions respectively to maintain low capacitance and hence faster switching times.

In order to ensure fast switching it is advantageous to control the current gain of the transistor T2 for optimum matching of the load presented at the collector output. The gain for one collector of an npn transistor (T2) in an SFL gate can be defined as the sum of the currents of all collectors in that transistor (measured with a collector base (T2) voltage of OV) divided by the current received by the base of T2 from a pnp injector transistor (T1) (measured with an emitter base voltage (T2) of OV). The optimum gain for fast switching depends upon the load presented to each collector and is typically twice the maximum fan out, N, per gate. A suitable maximum fan out for design is 4 which gives an optimum gain, 2N, of 8. This control of the current gain may be effected by means of adjusting either or both of the integrated doping density or the band gap of the semi-conductive region between the emitter junction and the base contact if the minority carrier recombination current at this contact is a substantial fraction of the total base current.

An example of a transistor in which the latter is the case is T2 in Fig. 3 where heterojunctions at the emitter-base and collector base junctions have been used to minimise other base recombination currents such that recombination at the contact itself dominates. If the doping density of layer 12 is uniform then the gain of the collectors of T2 can be substantially optimised to 2N by adjusting the ratio of the integrated doping beneath the collector(s) to that of the integrated doping beneath the base contact(s).

When the doping density of the layer 13 of Figure 3 is low enough to form a Schottky diode between the electrical contact 14 and the layer 13, the equivalent circuit of Figure 5 will be modified in the manner indicated by the broken line i.e. a Schottky diode SDI will be connected to the base of the transistor T2.

It should be noted that within practical limits any number, including one, of the semiconductive regions 16 can be provided in the region 23 of the layer 13, the number that is provided being dependent on the requirements of the transistor T2.

With the exemplified integrated circuit arrangement, the $V_{be1}$ of the transistor T1 is approximately 150 millivolts higher than the $V_{be2}$ of the transistor T2. This means that the pnp transistor T1 will not be saturated during operation and therefore the efficiency of the transistor T1 as a current source will be relatively high. As a consequence of this efficiency the delay power factor of the MCL will be reduced in comparison to known arrangements.

A plurality of isolated regions could be formed in the layer 13 in order to provide a plurality of MCLs in a single structure. With this arrangement the layers 11 and 12 would be common to all the MCLs and the desired number of semiconductive regions 16 would be formed on, and the desired number of electrical contacts 14 would be formed on, each of the isolated regions of the layer 13.

A typical arrangement for an array of MCLs in a single structure is diagrammatically illustrated in Figure 6 of the drawings in a plan view. As illustrated in Figure 6, each region 23 of the layer 13 and the associated semiconductive regions 16 and electrical contacts 14 and 17 are isolated from the other regions by the surrounding isolation sections 24.

Each of the MCLs of the array can be utilised as an element in the construction of a variety of logic functions, for example, bistables, modulo-2 adders etc.

Also, the interconnected isolation sections 24 can be used as the negative power supply rail, for the layer 12 i.e. the bases of the transistors T1 and the emitters of the transistors T2, by arranging for the resistivity of the sections 24 to be of a suitable low value. This feature therefore eliminates the need for a separate negative supply rail and because the positive supply is applied to the terminal 22 (see Figure 3), the whole of the surface area of the arrangement is available for logical interconnections.

Alternatively, if isolation is achieved by mesa etching the doping in region 12 can be made as high as required for low resistivity without compromising the emitter efficiency of T1 by making the junction between region 11 and region 12 a heterojunction.

When Schottky diodes are formed between the electrical contacts 14 and the layers 13, the contacts 14 now being the gate inputs have the effect of (a) clamping the bases of the transistors T2 resulting in a reduction in the voltage swing of the base of the transistor T2 and in the delay power product, (b) providing, when a number of contacts 14 are formed on each region 23, logic circuit elements with multi-inputs as well as multi-outputs and (c) allowing direct compatibility with transistor-transistor logic (TTL). Also, because the bases of the transistors T2 are connected through schottky diodes, there cannot be current hogging and therefore many inputs can be connected together and be driven from a common rail or gate input.

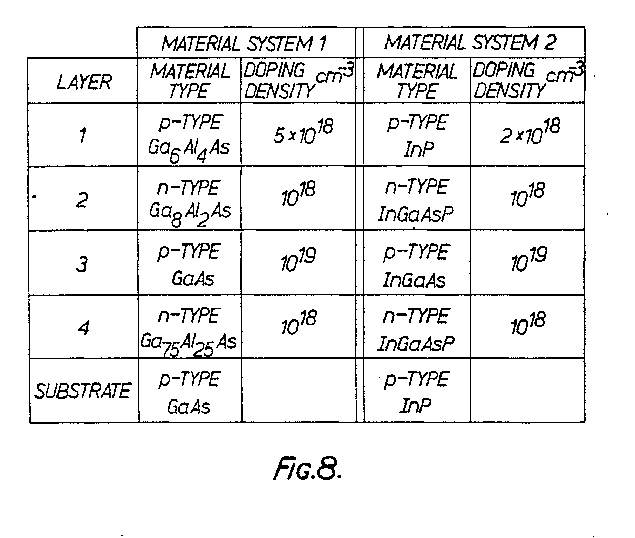

The layer structure is preferably formed on a substrate as shown in Figure 7 in which case provided the substrate is arranged to be conductive the connection to the layer 11 can be made directly thereto (not shown) or via the substrate 30 by means of a layer 31 of an electrical contact material formed on the surface of the substrate in any known manner. Where a semi insulating or insulating substrate is used, connection is made to the layer 11 after etching through layers 16, 13 and 12. Either structure enables the implementation of individual transistors, diodes, capacitors and resistors and enables emitter coupled logic (ECL) and analogue circuitry to be fabricated and interconnected on the same chip as I²L circuitry. This capability is provided by isolating down to the substrate by any suitable means e.g. mesa etching, proton implantation or p-type dopant implantation to form islands which can be used to fabricate individual components or circuits. Use of the heterojunction between layers 11 and 12 as the emitter-base of upward transistors allows them to have similar performance to the more usual isolated downward npn transistors which can also have a heterojunction emitter-base (layers 13 and 12) and the combination will be of particular value in high speed ECL and analogue circuits.

## Claims

1. An integrated circuit arrangement having at least one pair of superposed transistor structures (T1, T2), the arrangement comprising first (11), second (12) and third (13) superposed semiconductor layers, the second layer (12) being of opposite conductivity type to the first and third layers, at least one electrical contact (15) formed on a surface of the third layer (13), at least one semiconductive region (16) of the same conductivity type as the second layer formed in or on the said surface of the third layer, an electrical connection (20) to the or each of the semiconductive region(s) and an electrical connection (22) to the first layer (11), characterized in that at least the second (12) and third (13) layers form a heterojunction ensuring a high injection efficiency of minority carrier independant of the doping level of either layer.

2. An integrated circuit arrangement as claimed in claim 1, wherein the electrical contact (22) to the first layer (11) comprises a layer of electrical contact material formed on a surface of the first layer.

3. An integrated circuit arrangement as claimed in claim 1, wherein the first layer is formed on a semiconductor substrate of like polarity type.

4. An integrated circuit arrangement as claimed in claim 3, wherein the layers are formed on the substrate by epitaxial deposition.

5. An integrated circuit arrangement as claimed in claim 3, wherein the substrate is of a conductive type and a layer of contact material is formed on a surface opposite the first layer to provide said electrical connection to the first layer.

6. An integrated circuit arrangement as claimed in any one of the preceding claims, wherein the first (11) and second (12) layers form a heterojunction.

7. An integrated circuit arrangement as claimed in any one of the preceding claims, wherein said at least one semiconductive region (16) forms with the third layer (13) a heterojunction. .

8. An integrated circuit arrangement as claimed in any one of the preceding claims, wherein the second layer (12) has a doping density higher than the first layer (11).

9. An integrated circuit arrangement as claimed in any one of the preceding claims, wherein the doping density on the wider band gap side of any heterojunction is reduced in the vicinity of that heterojunction.

10. An integrated circuit arrangement as claimed in any one of the preceding claims, wherein the doping density at the surface of the third layer beneath said at least one electrical contact is more heavily doped than the remainder of the layer.

11. An integrated circuit arrangement as claimed in any one of claims 1 to 8, wherein the surface of the third layer beneath said at least one electrical contact is arranged to have a wider band gap than the remainder of the layer.

12. An integrated circuit structure as claimed in any one of the preceding claims provided with N said semiconductive regions (16) forming the collectors of the multicollector I²L circuit and wherein the current gain of the transistor is arranged to be substantially 2N.

13. An integrated circuit structure as claimed in claim 12 where the current gain is limited to 2N by ensuring a sufficient minority carrier recombination at the base contact.

14. An integrated circuit arrangement as claimed in any one of the preceding claims fabricated in Gallium Arsenide and Gallium Aluminium Arsenide.

15. An integrated circuit arrangement as claimed in any one of claims 1 to 13 fabricated in Gallium Indium Arsenide and Indium Phosphide.

16. An integrated circuit arrangement as claimed in any one of claims 1 to 15, wherein the doping density of the third layer is such that said at least one electrical contact forms a Schottky diode with the third layer.

17. An integrated circuit arrangement as claimed in any one of the preceding claims wherein the first and third layers are of p type conductivity and the second layer and said at least one semiconductive regions are of n type conductivity.

18. An integrated circuit arrangement as claimed in any one of the preceding claims having a plurality of pairs of superposed trainsistor structures wherein the first and second layers are common to all of the pairs and wherein the third layer is divided into a number of separate sections which are isolated from each other and which are each associated with a separate one of the pairs, each of the separate sections having at least one electrical contact formed on the surface thereof, at least one said semiconductive region formed in or on the surface thereof and an electrical contact for each of the semiconductive regions.

19. An integrated circuit arrangement as claimed in claim 18, wherein the separate sections are isolated from each other by an interconnected isolation strip (24) which is adapted to provide an electrical contact rail for the second layer.

20. An integrated circuit arrangement as claimed in claim 3, or any one of the preceding claims when dependent from claim 3, in which at least one island is formed by providing an isolating region which extends down to the substrate, which island is used to fabricate an individual transistor, diode, resistor, capacitor or circuit on the same chip as the pairs(s) of superposed transistor structures.

21. An integrated circuit arrangement as claimed in claim 20 wherein the isolating region is formed by mesa etching.

22. An integrated circuit arrangement as claimed in claim 20 wherein the isolating region is formed by proton implantation.

23. An integrated circuit arrangement as claimed in claim 20 wherein the isolating region is formed by p-type dopant implantation.

**Patentansprüche**

1. Integrierte Schaltungsanordnung, mit mindestens einem Paar überlagerter Transistorstrukturen (T1, T2), wobei die Anordnung erste (11), zweite (12) und dritte (13) überlagerte Halbleiterschichten umfasst, dabei die zweite Schicht (12) bezüglich der ersten und dritten Schichten von entgegengesetztem Leitungstyp ist, mit mindestens einem elektrischen Kontakt (15), auf einer Oberfläche der dritten Schicht (13) geformt, wobei mindestens ein halbleitender Bereich (16) desselben Leitungstyps, wie die zweite Schicht in oder auf besagter Oberfläche der dritten Schicht geformt ist, weiter mit einer elektrischen Verbindung (20) zum oder zu jedem der halbleitenden Bereiche und einer elektrischen Verbindung (22) zur ersten Schicht (11), dadurch gekennzeichnet, dass mindestens die zweiten (12) und dritten (13) Schichten einen Heteroübergang bilden, der einenn hohen Injektions-wirkungsgrad von Minoritätsträgern sicherstellt, unabhängig von der Dotierungsdichte jeder der beiden Schichten.

2. Integrierte Schaltungsanordnung nach Anspruch 1, bei der die elektrische Verbindung (22) zur ersten Schicht (11) eine Schicht aus elektrischem Kontaktmaterial umfasst, auf einer Oberfläche der ersten Schicht vorgesehen.

3. Integrierte Schaltungsanordnung nach Anspruch 1, bei der die erste Schicht auf einem Halbleiter-Substrat ausgebildet ist, von gleichem Polaritätstyp.

4. Integrierte Schaltungsanordnung nach Anspruch 3, bei der die Schichten auf dem Substrat durch epitaxiale Ablagerung gebildet sind.

5. Integrierte Schaltungsanordnung nach Anspruch 3, bei der das Substrat eines Leitungstyps ist und eine Schicht aus Kontaktmaterial auf einer Oberfläche gegenüber der ersten Schicht ausgebildet ist, um die besagte elektrische Verbindung zur ersten Schicht herzustellen.

6. Integrierte Schaltungsanordnung nach einem der vorstehenden Anpsrüche, bei der die ersten (11) und die zweiten (12) Schichten einen Heteroübergang bilden.

7. Integrierte Schaltungsanordnung nach einem der vorstehenden Ansprüche, bei der besagter mindestens ein halbleitender Bereich (16) mit der dritten Schicht (13) einen Heteroübergang bildet.

8. Integrierte Schaltungsanordnung nach einem der vorstehenden Ansprüche, bei der die zweite Schicht (12) eine Dotierungsdichte hat, die grösser ist, als die der ersten Schicht (11).

9. Integrierte Schaltungsanordnung nach einem der vorstehenden Ansprüche, bei der die Dotierungsdichte auf der breiteren Bandabstandsseite von irgend einem Heteroübergang in der Nähe dieses Heteroüberganges reduziert ist.

10. Integrierte Schaltungsanordnung nach irgend einem der vorstehenden Anpsrüche, bei der die Dotierungsdichte an der Oberfläche der dritten Schicht, unter besagtem mindestens einen elektrischen Kontakt, stärker dotiert ist als der Rest der Schicht.

11. Integrierte Schaltungsanordnung nach einem der Ansprüche 1 bis 8, bei der die Oberfläche der dritten Schicht unterhalb besagtem mindestens einen elektrischen Kontakt so ausgelegt ist, dass sie einen breiteren Bandabstand aufweist als der Rest der Schicht.

12. Integrierte Schaltungsanordnung nach einem der vorstehenden Ansprüche, bei der N besagter halbleitender Bereiche (16) vorgesehen sind, welche die Kollektoren der Multikollektor-$I^2$L-Anordnung bilden, und worin die Stromverstärkung des Transistors auf im wesentlichen 2N ausgelegt ist.

13. Integrierte Schaltungsanordnung nach Anspruch 12, bei der die Stromverstärkung auf 2N dadurch limitiert ist, dass eine genügende Minoritätsträger-Rekombination am Basiskontakt sichergestellt ist.

14. Integrierte Schaltungsanordnung nach einem der vorstehenden Ansprüche, die in Gallium-Arsenid und Gallium-Aluminium-Arsenid hargestellt ist.

15. Integrierte Schaltungsanordnung nach einem der Ansprüche 1 bis 13, in Gallium-Indium-Arsenid und Indium-Phosphid hergestellt.

16. Integrierte Schaltungsanordnung nach einem der Ansprüche 1 bis 15, bie der die Dotierungsdichte der dritten Schicht so ist, dass besagter mindestens eine elektrische Kontakt eine Schottky-Diode mit der dritten Schicht bildet.

17. Integrierte Schaltungsanordnung nach irgend einem der vorstehenden Anpsrüche, bei der die ersten und dritten Schichten vom p-Leitungstyp sind und die zweite Schicht und besagte mindestens eine Halbleiterbereiche vom n-Leitungstyp sind.

18. Integrierte Schaltungsanordnung nach einem der vorstehenden Ansprüche mit einer Vielzahl Paaren überlagerter Transistorstrukturen, worin die ersten und zweiten Schichten allen Paaren gemeinsam sind und worin die dritte Schicht in eine Anzahl separater Abschnitte unterteilt ist, die voneinander isoliert sind, und je mit einem separaten der Paare verbunden sind, wobei jeder der separaten Abschnitte mindestens einen elektrischen Kontakt auf seiner Oberfläche aufweist, weiter mindestens eine besagter halbleitender Bereiche in oder auf seiner Oberfläche und einen elektrischen Kontakt für jeden der Halbleiterbereiche.

19. Integrierte Schaltungsanordnung nach Anspruch 18, bei der die separaten Abschnitte durch einen zwischengeschalteten isolationsstreifen (24) voneinander isoliert sind, welcher so angebracht ist, dass er eine elektrische Kontaktschiene für die zweite Schicht bildet.

20. Integrierte Schaltungsanordnung nach Anspruch 3 oder einem der vorstehenden Ansprüche, wenn von Anspruch 3 abhängig, bei der mindestens eine Insel durch Vorsehen eines Isolationsbereiches ausgebildet ist, der sich nach unten bis zum Substrat erstreckt, wobei diese Insel zur Herstellung eines individuellen Transistors, einer Diode, eines Wilderstandes, Kondensators oder Stromkreises auf demselben Chip, auf dem das Paar oder die Paare überlagerter Transistorstrukturen sind, dient.

21. Integrierte Schaltungsanordnung nach Anspruch 20, bei der der Isolationsbereich durch Mesa-Aetzung gebildet ist.

22. Integrierte Schaltungsanordnung nach Anspruch 20, bei der der Isolationsbereich durch Protonen-Implantation gebildet ist.

23. Integrierte Schaltungsanordnung nach Anspruch 20, bei der der Isolationsbereich durch p-Typ-Dotierungs-Implantation gebildet ist.

**Revendications**

1. Arrangement de circuit intégré ayant au moins une paire de structures superposées à transistors (T1, T2), l'arrangement comprenant une première (11), une seconde (12) et une troisième (13) couche semi-conductrice superposées, la seconde couche (12) ayant un type de conductivité opposé à celui de la première et de la troisième couche, au moins un contact électrique (15) formé sur une face de la troisième couche (13), au moins une région semi-conductrice (16) de même type de conductivité que la seconde couche, formée dans la surface de la troisième couche ou sur cette surface, une connexion électrique (20) formée avec la région semi-conductrice ou chaque région semi-conductrice et une connexion électrique (22) formée avec la première couche (11), caractérisé en ce que la seconde (12) et la troisième (13) couche au moins forment un hétérojonction assurant un rendement d'injection élevé des porteurs minoritaires indépendamment du niveau de dopage de l'une ou l'autre couche.

2. Arrangement de circuit intégré selon la revendication 1, dans lequel le contact électrique (22) formé avec la première couche (11) comporte une couche d'un matériau de contact électrique formée sur une surface de la première couche.

3. Arrangement de circuit intégré selon la revendication 1, dans lequel la première couche est formée sur un substrat semi-conducteur de type analogue de polarité.

4. Arrangement de circuit intégré selon la revendication 3, dans lequel les couches sont formées sur le substrat par dépôt épitaxial.

5. Arrangement de circuit intégré selon la revendication 3, dans lequel le substrat est d'un type conducteur et une couche d'un matériau de contact est formée sur une surface opposée à la première couche afin qu'il assure la connexion électrique à la première couche.

6. Arrangement de circuit intégré selon l'une quelconque des revendications précédentes, caractérisé en ce que la première et la seconde couche (11, 12) forment une hétérojonction.

7. Arrangement de circuit intégré selon l'une quelconque des revendications précédentes, caractérisé en ce qu'une région semi-conductrice (16) au moins forme une hétérojonction avec la troisième couche (13).

8. Arrangement de circuit intégré selon l'une quelconque des revendications précédentes, dans lequel la seconde couche (12) a une densité de dopage supérieure à celle de la première couche (11).

9. Arrangement de circuit intégré selon l'une quelconque des revendications précédentes, dans lequel la densité de dopage d'une hétérojonction quelconque du côté d'une bande interdite plus large est réduite au voisinage de cette hétérojonction.

10. Arrangement de circuit intégré selon l'une quelconque des revendications précédentes, dans lequel la densité de dopage à la surface de la troisième couche au-dessous du contact électrique au moins est supérieure à celle du reste de cette couche.

11. Arrangement de circuit intégré selon l'une quelconque des revendications 1 à 8, dans lequel la surface de la troisième couche, au-dessous d'au moins un contact électrique, est réalisée de manière que sa bande interdite soit plus large que le reste de la couche.

12. Structure de circuit intégré selon l'une quelconque des revendications précédentes, ayant N régions semi-conductrices (16) formant les collecteurs du circuit I²L à plusieurs collecteurs, et dans laquelle le gain en courant du transistor est réalisé afin qu'il soit sensiblement égal à 2N.

13. Structure de circuit intégré selon la revendication 12, dans laquelle le gain en courant est limité à 2N par réalisation d'une recombinaison suffisante des porteurs minoritaires au niveau du contact de base.

14. Arrangement de circuit intégré selon l'une quelconque des revendications précédentes, fabriqué en arséniure de gallium et en arséniure de gallium et d'aluminium.

15. Arrangement de circuit intégré selon l'une quelconque des revendications 1 à 13, fabriqué en arséniure de gallium et d'indium et en phosphure d'indium.

16. Arrangement de circuit intégré selon l'une quelconque des revendications 1 à 15, dans lequel la densité de dopage de la troisième couche est telle que le contact électrique au moins forme une diode de Schottky avec la troisième couche.

17. Arrangement de circuit intégré selon l'une quelconque des revendications précédentes, dans lequel la première et la troisième couche ont une conductivité de type p et la seconde couche et au moins une région semi-conductrice ont une conductivité de type n.

18. Arrangement de circuit intégré selon l'une quelconque des revendications précédentes, ayant plusieurs paires de structures superposées à transistors dans lesquelles la première et la seconde couche sont communes à toutes les paires, et la troisième couche est divisée en un certain nombre de tronçons séparés qui sont isolés les uns des autres et qui sont associés chacun à l'une des paires séparées, chacun des tronçons séparés ayant au moins un contact électrique formé à sa surface, au moins une région semi-conductrice formée dans sa surface ou sur sa surface et un contact électrique pour chacune des régions semi-conductrices.

19. Arrangement de circuit intégré selon la revendication 18, dans lequel les tronçons séparés sont isolés les uns des autres par une bande interconnectée (24) d'isolement qui est destinée à former un rail de contact électrique pour la seconde couche.

20. Arrangement de circuit intégré selon la revendication 3 ou selon l'une quelconque des revendications précédentes dépendant de la revendication 3, dans lequel un îlot au moins est formé par réalisation d'une région isolante qui rejoint le substrat, l'îlot étant utilisé pour la fabrication d'un transistor, d'une diode, d'une résistance, d'un condensateur ou d'un circuit individuel sur la même pastille que la paire ou les paires de structures superposées à transistors.

21. Arrangement de circuit intégré selon la revendication 20, dans lequel la région d'isolement est formée par attaque chimique d'une structure mésa.

22. Arrangement de circuit intégré selon la revendication 20, dans lequel la région isolante est formée par implantation de protons.

23. Arrangement de circuit intégré selon la revendication 20, dans lequel la région d'isolement est formée par implantation d'une matière de dopage de type p.

| n | c |  |  |  | 4 |
|---|---|---|---|---|---|
| p | b | T2 | c |  | 3 |
| n | e |  | b | T1 | 2 |
| p |  |  | e |  | 1 |

**Fig.1.**

| c | 7 |
|---|---|
| b | 6 |
| e | 5 |

**Fig.2.**

**Fig.3.**

**Fig.4.**

**Fig.5.**

FIG.6.

| n | WIDE BAND GAP |
|---|---|
| p | NARROW BAND GAP |
| n | WIDE BAND GAP |
| p | WIDER BAND GAP |
| p type substrate | |

FIG.7.

| LAYER | MATERIAL SYSTEM 1 | | MATERIAL SYSTEM 2 | |
|---|---|---|---|---|
| | MATERIAL TYPE | DOPING DENSITY $cm^{-3}$ | MATERIAL TYPE | DOPING DENSITY $cm^{-3}$ |
| 1 | p-TYPE $Ga_6Al_4As$ | $5 \times 10^{18}$ | p-TYPE InP | $2 \times 10^{18}$ |
| 2 | n-TYPE $Ga_8Al_2As$ | $10^{18}$ | n-TYPE InGaAsP | $10^{18}$ |
| 3 | p-TYPE GaAs | $10^{19}$ | p-TYPE InGaAs | $10^{19}$ |
| 4 | n-TYPE $Ga_{75}Al_{25}As$ | $10^{18}$ | n-TYPE InGaAsP | $10^{18}$ |
| SUBSTRATE | p-TYPE GaAs | | p-TYPE InP | |

## FIG.8.